# EUROPÄISCHE PATENTSCHRIFT

(11) **EP 0 649 063 B1**
(45) Veröffentlichungstag und Bekanntmachung des Hinweises auf die Patenterteilung: **29.01.1997**
(21) Anmeldenummer: 94116059.0
(22) Anmeldetag: 12.10.1994
(51) Int. Cl.: G03F 7/115

(54) **Mattiertes, strahlungsempfindliches Aufzeichnungsmaterial**
Matted radiation-sensitive recording material
Matériau d'enregistrement photosensible, mat

(30) Priorität: 18.10.1993 DE 4335425
(43) Veröffentlichungstag der Anmeldung: 19.04.1995
(73) Patentinhaber: Agfa-Gevaert AG, D-51373 Leverkusen (DE)
(72) Erfinder: Frass, Werner, Dr., D-65207 Wiesbaden (DE); Gaschler, Otfried, D-65205 Wiesbaden (DE); Joerg, Klaus, Dr., D-55218 Ingelheim (DE); Hultzsch, Günter, Dr., D-65187 Wiesbaden (DE); Elsässer, Andreas, Dr., D-65510 Idstein (DE)

(56) Entgegenhaltungen:
- EP-A- 0 174 588
- EP-A- 0 528 395
- GB-A- 2 081 919

## Beschreibung

Die Erfindung betrifft ein Aufzeichnungsmaterial mit einem Träger, einer strahlungsempfindlichen Schicht, die ein 1,2-Naphthochinon-2-diazid und ein in Wasser unlösliches, in wäßrig-alkalischen Lösungen dagegen lösliches, organisches, polymeres Bindemittel enthält, und einer darauf befindlichen, nicht durchgehenden Mattierungsschicht.

Der erste Schritt bei der Herstellung von Flachdruckplatten ist üblicherweise das bildmäßige Bestrahlen der strahlungsempfindlichen Aufzeichnungsmaterialien in einem Vakuum-Kontaktkopierrahmen. Dabei soll die Vorlage möglichst rasch in engen Kontakt zu dem Aufzeichnungsmaterial gebracht werden. Nach dem Evakuieren sollen keine Lufteinschlüsse zwischen Vorlage und Aufzeichnungsmaterial zurückbleiben. Auch der während des Bestrahlens aus dem Chinondiazid freigesetzte Stickstoff soll möglichst rasch abgeführt werden, damit sich keine Stickstoffeinschlüsse bilden. Beide Forderungen lassen sich mit einem Aufzeichnungsmaterial, dessen strahlungsempfindliche Schicht oberflächig aufgerauht ist, erfüllen. Eine rauhe Oberfläche kann beispielsweise durch Bestäuben vor dem bildmäßigen Bestrahlen erzielt werden. Ein solches Verfahren erzeugt jedoch meist ungleichmäßig aufgerauhte Oberflächen, so daß auch ungleichmäßige Kopierresultate erzielt werden.

Die Hersteller der strahlungsempfindlichen Aufzeichnungsmaterialien haben sich daher bemüht, ihre Produkte bereits mit einer definiert rauhen Oberfläche zu versehen. Dabei kamen verschiedene Verfahren zum Einsatz. So kann das Trägermaterial mit einer strahlungsempfindlichen Lösung beschichtet werden, in der wasserlösliche Partikel suspendiert sind, die nach dem Trocknen der Schicht mit Wasser ausgewaschen werden. Die Oberfläche der strahlungsempfindlichen Schicht weist danach eine Vielzahl an Vertiefungen auf.

Es wurde auch vorgeschlagen, der Beschichtungslösung eine Verbindung zuzusetzen, die beim Erhitzen auf 80 bis 300 °C gasförmigen Stickstoff abspaltet. Besonders geeignet sind Nitroso-, Sulfonylhydrazin-, Azo- oder Hydrazo-Verbindungen. Beim Trocknen im vorgenannten Temperaturbereich tritt der Abspaltungsprozeß ein. Auf diese Weise erhält die strahlungsempfindliche Schicht eine rauhe Oberfläche.

Schließlich wurde auch vorgeschlagen, eine strahlungsempfindliche Beschichtungslösung mit einem darin dispergierten Harz zu verwenden, das während des Trocknens ausflockt und ausfällt und auf diese Weise die Oberflächenstruktur verbessert. Keines dieser Verfahren hat sich jedoch bisher durchsetzen können.

Eine rauhe Oberfläche kann auch durch Auftragen von durchgehenden oder unterbrochenen Mattierungsschichten erreicht werden. So ist in der DE-A 30 09 928 (= GB-A 2 046 461) ein Verfahren beschrieben, bei dem eine lichtempfindliche Schicht mit einer nicht-lichtempfindlichen Beschichtungsflüssigkeit überzogen wird, die in dispergierter Form Teilchen aus Polyethylen, Polypropylen, Ethylen/Propylen-Copolymer, Ethylen/Vinylacetat-Copolymer, Polyethylenterephthalat oder einem vernetzten Vinylpolymer enthält. Nach dem Trocknen verbleiben die einzelnen Teilchen als sehr kleine Vorsprünge in der durchgehenden Deckschicht.

Durchgehende oder unterbrochene Deckschichten mit definierter Oberflächenrauheit lassen sich mit Hilfe einer Prägewalze auftragen. Die dafür verwendeten Beschichtungslösungen können konventionelle Mattierungsmittel, wie Siliciumdioxid, Zinkoxid, Titandioxid, Glasperlen, Aluminiumoxid, Stärke, Poly(methylmethacrylat), Polystyrol und Phenolharze, enthalten (DE-A 26 06 793 = GB-A 1 542 131).

Schließlich kann eine Mattierung auch durch Aufstäuben eines feinen Pulvers erzeugt werden, das an der Oberfläche der lichtempfindlichen Schicht angeschmolzen wird. Es muß dazu einen niedrigeren Erweichungspunkt besitzen als die lichtempfindliche Schicht. Die Mattierungsteilchen bestehen im allgemeinen aus Polyvinylacetat, Polyvinylidenchlorid, Polyethylenoxid, Polyethylenglykol, Polyacrylsäure, Polymethacrylsäure, Polyacrylamid, Polymethacrylamid, Polybutylacrylat, Polystyrol, Polyvinylmethylether, Epoxyharze, Phenolharze, Polyamide oder Polyvinylbutyral (DE-A 30 03 131 = US-A 4 288 521).

Aus der DE-A 31 31 570 (= GB-A 2 081 919) ist ein Aufzeichnungsmaterial mit einer lichtempfindlichen Schicht und einer darauf befindlichen Mattierungsschicht bekannt. Die Mattierungsschicht wird durch Aufsprühen und Trocknen einer wäßrigen Lösung oder Dispersion, in der ein organisches Copolymer enthalten ist, aufgetragen. Das Aufsprühen kann auch elektrostatisch erfolgen. Die strahlungsempfindliche Schicht kann ein 1,2-Naphthochinon-2-diazid und ein polymeres Bindemittel enthalten. Wie Beispiel 1 zeigt, müssen die Mattierungsschichten beim Entwickeln entfernbar sein. Eine Mattierungsschicht mit Copolymeren, die einen Gehalt an Polymereinheiten mit Salzgruppen von 12 Gew.-% oder mehr aufweist, erfüllt diese Bedingung. Wird jedoch ein Copolymer mit nur 4 Gew.-% an Na-Acrylat-Einheiten verwendet, so wird die Mattierung nicht mehr vollständig entfernt, und es treten als Folge davon Verfärbungen (Fleckenbildung) beim Drucken auf.

Gemäß der EP-A 0 344 985 wird das Material, das die unterbrochene Mattierungsschicht ergibt, in einem Kohlenwasserstoff mit einer bestimmten niedrigen Leitfähigkeit gelöst oder dispergiert und elektrostatisch auf die strahlungsempfindliche Schicht aufgesprüht. Das zur Mattierung verwendete Material kann auch lichtempfindlich sein. Vorteil des Verfahrens ist, daß die auf die Schicht auftreffenden Tröpfchen eine weitgehend einheitliche Größe aufweisen.

In der DE-A 34 33 247 (= US-A 4 842 982) ist ein strahlungsempfindliches Aufzeichnungsmaterial beschrieben, bei dem auf die strahlungsempfindliche Schicht eine rauhe Deckschicht aufgesprüht und getrocknet wird. Beide Schichten haben im wesentlichen die gleiche Zusammensetzung. Wird das Aufzeichnungsmaterial nur kurz belichtet, wie es für Feinrasterarbeiten erforderlich sein kann, so verbleiben nach dem Entwickeln häufig noch Reste der Schicht in den Nichtbildbereichen. Diese müssen dann in einem zusätzlichen Korrekturschritt entfernt werden.

Eine weitere Möglichkeit, ein mattiertes, lichtempfindliches Aufzeichnungsmaterial herzustellen, besteht darin, in die lichtempfindliche Schicht feinteilige Partikel einzubringen, deren kleinste Abmessung mindestens so groß ist wie die Dicke der Schicht. Die Partikel können anorganischer oder organischer Natur sein (DE-A 29 26 236 = AU-B 59 417/80). Thermisch gehärtete Phenolharze werden als besonders geeignet beschrieben (DE-A 31 17 702 = GB-A 2 075 702).

In der JP-A 57-115 548 ist ein Aufzeichnungsmaterial offenbart, dessen strahlungsempfindliche Schicht hydrophobe Siliciumdioxid-Teilchen mit einem mittleren Durchmesser von weniger als 500 µm sowie Mattierungsteilchen aus Polyethylen, Polypropylen, Ethylen/Propylen-Copolymer oder vernetzten Vinyl-Polymeren mit einem mittleren Durchmesser von 3 bis 40 µm enthält. Die SiO₂-Partikel dienen zur Dispergierung der Mattierungsteilchen.

Ein Aufzeichungsmaterial, in dem die strahlungsemfindliche Schicht selbst mattiert ist, bietet den Vorteil, daß nach bildmäßiger Belichtung und nachfolgender Entwicklung die Mattierung an den Bildstellen erhalten bleibt. Die beschriebenen separaten Mattierungsschichten sind dagegen im Entwickler löslich oder dispergierbar und werden praktisch vollständig entfernt. Um die Mattierungsteilchen in der strahlungsempfindlichen Schicht herum kann jedoch eine Hofbildung auftreten. Auch können die Mattierungsteilchen Agglomerate bilden.

Es bestand somit die Aufgabe, ein mattiertes, strahlungsempfindliches Aufzeichnungsmaterial bereitzustellen, das die Nachteile der bekannten Materialien nicht aufweist. Insbesondere soll es in den Nichtbildstellen rückstandsfrei entwickelbar sein. An den Bildstellen soll die Mattierung dagegen erhalten bleiben.

Gelöst wird die Aufgabe mit einer wäßrigen, anionisch oder anionisch/nichtionisch stabilisierten Dispersion eines Harzes, das pro Gramm bis zu 0,80 mmol an Säure- und/oder Salzgruppen enthält.

Gegenstand der vorliegenden Anmeldung ist somit ein Aufzeichnungsmaterial mit einem Träger, einer strahlungsempfindlichen Schicht, die ein 1,2-Naphthochinon-2-diazid und ein in Wasser unlösliches, in wäßrigalkalischen Lösungen dagegen lösliches, organisches, polymeres Bindemittel enthält, und einer darauf befindlichen Mattierungsschicht aus diskreten Partikeln, das dadurch gekennzeichnet ist, daß die Partikel in einer Menge von 100 bis 10.000 Partikeln/cm² vorliegen und einen mittleren Durchmesser von weniger als 40 µm, einen maximalen Durchmesser von weniger als 80 µm, eine mittlere Höhe von 2 bis 6 µm und eine maximale Höhe von 10 µm aufweisen und ein Harz enthalten, das pro Gramm bis zu 0,80 mmol Säure- und/oder Salzgruppen aufweist, und daß die Mattierungsschicht durch Aufsprühen und Trocknen einer wäßrigen, anionisch oder anionisch/nichtionisch stabilisierten Dispersion des Harzes erhalten wurde.

Für die Mattierungsschicht besonders geeignete Harze sind Polymere, die Sulfo-, Carboxy- und/oder Phosphonogruppen entweder in freier Form oder als Salz mit einem ein- oder mehrwertigen Kation enthalten. Wesentlich ist, daß der Gehalt an Säure und/oder Salzgruppen nicht mehr als 0,8 mmol/g beträgt. Liegt er darüber, so wird die Mattierung an den Bildstellen beim Entwickeln mitentfernt. Bei einem Gehalt an Säure- und/oder Salzgruppen im Harz unter 0,01 mmol/g ist ein anionischer Stabilisator zwingend erforderlich, da sonst Spots in den Nichtbildstellen auftreten.

Bevorzugt sind Harze mit einem Gehalt an Säure- und/oder Salzgruppen von 0,03 bis 0,75 mmol/g.

Die Kationen in den genannten Salzen sind insbesondere Na⁺, K⁺, NH₄⁺, Ca²⁺, Zn²⁺ oder Al³⁺. Die Harze sind gewöhnlich Polykondensations- oder Polyadditionsverbindungen. Geeignete Polymere sind beispielsweise Polyester, Polyamide, Polyurethane oder Polyharnstoffe, die die genannte molare Menge an Säure- und/oder Salzgruppen aufweisen. Dabei sind die Säure- oder Salzgruppen in der Regel an die Diol- oder Diamin-Einheiten in diesen Polymeren gebunden.

Geeignet sind auch Copolymere mit a) Einheiten aus Acrylsäure, Methacrylsäure, Itaconsäure, Maleinsäure, Ethylensulfonsäure (= Vinylsulfonsäure), Styrolsulfonsäure, 2-Acryloylamino-1,1-dimethyl-ethansulfonsäure, Vinylphosphonsäure, und/oder 2-Acryloylamino-1,1-dimethyl-ethylphosphonsäure (= Acrylamido-isobutylenphosphonsäure) sowie deren Salzen und b) Einheiten aus Acrylsäureestern, Methacrylsäureestern, Acrylamiden, Methacrylamiden, Styrol, Vinylestern und/oder Vinylethern. Die Einheiten (a) können auch aus Phosphinsäuren, wie Methyl-vinyl-phosphinsäure, stammen. Die molare Menge der Einheiten (a) mit Säure- oder Salzgruppen ist auch in den Polyadditionsverbindungen so gewählt, daß die Polymere pro Gramm bis zu 0,80 mmol, bevorzugt 0,01 bis 0,75 mmol, an diesen Gruppen enthalten. Die Säure- oder Salzgruppen sind bevorzugt Carboxy-, Carboxylat, Sulfo-, Sulfonat-, Phosphono- oder Phosphonatgruppen.

In einer besonderen Ausführungsform sind auch Harze verwendbar, die keine oder weniger als die oben genannte Mindestmenge an Säure- oder Salzgruppen enthalten. Dann müssen die wäßrigen Dispersionen allerdings mit anionischen oberflächenaktiven Verbindungen stabilisiert sein. Diese Verbindungen enthalten Anionen der allgemeinen Formel

R¹O-(CH₂-CHR²-O)ₙ-Y,

worin
- R¹: einen (C₆-C₂₀)Alkylrest oder einen gegebenenfalls (C₁-C₁₈)alkylsubstituierten (C₆-C₁₂)Arylrest,
- R²: ein Wasserstoffatom oder eine Methylgruppe,
- Y: eine SO₃⁻-, CH₂-CO₂⁻ oder PO₃²⁻-Gruppe und
- n: eine ganze Zahl zwischen 0 und 50
darstellt.

Die Kationen in den oberflächenaktiven Verbindungen sind im allgemeinen Natrium-, Kalium-, Ammonium-, Diethanolammonium- oder Triethanolammonium-Ionen.

Die anionischen oberflächenaktiven Mittel können auch zusammen mit den obengenannten Harzen mit 0,01 bis 0,80 mmol/g an Säure- und/oder Salzgruppen verwendet werden. Der Anteil der ionischen oberflächenaktiven Mittel beträgt 1 bis 20 Gew.-%, jeweils bezogen auf das Gesamtgewicht der nichtflüchtigen Bestandteile der Dispersion.

Die sprühfähige Dispersion kann zusätzlich noch nichtionische oberflächenaktive Verbindungen und/oder wasserlösliche Schutzkolloide enthalten. Geeignete nicht-ionische oberflächenaktive Verbindungen sind beispielsweise Verbindungen der allgemeinen Formel, in denen Y für ein Wasserstoffatom steht und R¹ zusätzlich zu den obengenannten Resten für ein Wasserstoffatom oder eine (C₁-C₅)Alkylgruppe stehen kann.

Der Anteil der nicht-ionischen oberflächenaktiven Verbindungen beträgt bis zu 10 Gew.-%, bezogen auf das Gesamtgewicht der nichtflüchtigen Bestandteile der Dispersion. Als Schutzkolloid sind insbesondere Homo- oder Copolymere des Vinylalkohols, Cellulosederivate, wie Methylcellulose, Hydroxyethylcellulose und Carboxymethylcellulose, Stärke und Stärkederivate, Gummi arabicum, Casein, Gelatine und Polyglykole geeignet. Der Anteil der Kolloide sollte nicht mehr als 30 Gew.-%, bezogen auf das Gesamtgewicht der nichtflüchtigen Bestandteile der Dispersion, betragen. Liegt der Anteil über dem angegebenen Prozentsatz, so kann es zu einer Ablösung der Mattierungsteilchen in den Bildstellen beim Entwickeln kommen.

Herstellen läßt sich das erfindungsgemäße Aufzeichungsmaterial durch Aufsprühen der obengenannten wäßrigen Dispersion, die bevorzugt einen Anteil von nichtflüchtigen Bestandteilen von 5 bis 50 Gew.-% hat, auf die strahlungsempfindliche Schicht. Das Aufsprühen erfolgt nach an sich bekannten Techniken, wie Flüssigkeitsdruckzerstäubung, wozu allgemein eine Einstoffdüse verwendet wird, Luftdruckzerstäubung (Zweistoffdüse), Ultraschallzerstäubung, elektrostatisches Sprühen oder durch Sprühen mit Hilfe einer mit hoher Geschwindigkeit (ca. 20.000 Umdrehungen pro Minute) rotierenden Sprühglocke, der sogenannten "Hochrotationsglocke". Zwischen Sprühglocke und dem zu mattierenden Substrat kann zusätzlich eine elektrische Spannung angelegt sein.

Die nachfolgende Trocknung erfolgt bei Temperaturen bis zu 140 °C, beispielsweise mit Hilfe von Infrarotstrahlern oder in einem Konvektionstrockner.

Die auf diese Weise aufgebrachten Mattierungspartikel liegen auf der strahlungsempfindlichen Schicht häufig in Form von mehr oder weniger abgeflachten Halbkugeln oder -ellipsoiden vor. Aufgrund ihrer Form werden die Mattierungspartikel auch als "Kalotten" bezeichnet.

Nach einer Evakuierungszeit im Vakuum-Kontaktkopierrahmen von 10 bis 60 s liegen Vorlage und Aufzeichnungsmaterial gleichmäßig aufeinander. Bei Verwendung eines Aufzeichnungsmaterials, das Kalotten mit einer Höhe von mehr als 10 µm aufweist, wird dagegen eine verschlechterte Wiedergabe von Feinzeichnungen festgestellt. Haben die Kalotten einen Durchmesser von mehr als 80 µm, verbleiben nach bildmäßigem Bestrahlen und Entwickeln noch Schichtreste in den Nichtbildbereichen. Als vorteilhaft haben sich Kalotten mit einem Durchmesser in der Schichtebene von weniger als 40 µm, ganz besonders von weniger als 20 µm erwiesen.

Die Anzahl der Kalotten pro Quadratzentimeter beträgt vorzugsweise 500 bis 5.000. Bei weniger als 100 Kalotten/cm² werden großflächige Raster häufig ungleichmäßig übertragen. Eine Anzahl von mehr als 10.000 Kalotten/cm² ist nicht nachteilig, bringt jedoch auch keine weitere Verbesserung.

Das 1,2-Naphthochinon-2-diazid ist in den erfindungsgemäßen Aufzeichnungsmaterialien bevorzugt ein Derivat der 1,2-Naphthochinon-2-diazid-5-sulfonsäure. Das Derivat ist besonders bevorzugt ein Ester. Soll aus dem normalerweise positiv arbeitenden Aufzeichnungsmaterial durch zusätzliche Verarbeitungsschritte ein negatives Bild erzeugt werden (Umkehrverfahren), dann ist es vorteilhafter, Derivate der 1,2-Naphthochinon-2-diazid-4-sulfonsäure einzusetzen. Geeignete 1,2-Naphthochinon-2-diazide sind in der DE-A 938 233 (= GB-A 739 654) sowie in der DE-A 28 28 037 (= US-A 4 266 001) offenbart. Der Anteil der 1,2-Naphthochinon-2-diazide in der strahlungsempfindlichen Schicht beträgt allgemein 3 bis 50 Gew.-%, bevorzugt 8 bis 25 Gew.-%, jeweils bezogen auf das Gesamtgewicht der nichtflüchtigen Bestandteile der Schicht.

Als alkalilösliche Bindemittel in der strahlungsempfindlichen Schicht sind besonders solche Polymere geeignet, die pro Gramm 1 bis 15 mmol phenolische Hydroxygruppen, Oximgruppen oder Sulfonamidgruppen enthalten. Dies sind z. B. Kresol-Formaldehyd-Novolake oder Copolymere des Hydroxystyrols, des Hydroxyphenyl- oder Dihydroxyphenylmethacrylats, des Hydroxyphenyl- oder Dihydroxyphenylmethacrylamids, des Hydroxybenzyl- oder Dihydroxybenzylmethacrylats oder des Hydroxybenzyl- oder Dihydroxybenzyl-methacrylamids. Das mittlere Molekulargewicht M_{w} der polymeren Bindemittel beträgt allgemein 5.000 bis 100.000. Der Anteil des Bindemittels richtet sich nach dem Anwendungszweck. Im allgemeinen beträgt er zwischen 30 und 90 Gew.-%, bevorzugt zwischen 55 und 85 Gew.-%, jeweils bezogen auf das Gesamtgewicht der Feststoffe in der Schicht.

Zur Erzielung spezieller Erfordernisse, wie Chemikalienbeständigkeit, Haftung, Färbung oder Farbveränderung beim Einbrennen kann die strahlungsempfindliche Schicht noch weitere Bestandteile wie Polyglykole, Fluor- oder Siliconadditive, Farbstoffe, Haftvermittler, feinteilige Pigmente, UV-Absorber, Diazostabilisatoren enthalten.

Um die bestrahlten Bereiche sichtbar zu machen, kann die Schicht noch geringe Mengen an Indikatorfarbstoffen und Verbindungen, die unter der Einwirkung aktinischer Strahlung Säure bilden, enthalten. Die Säure bewirkt dann einen Farbumschlag bei einem Indikatorfarbstoff. Geeignete Säurebildner sind beispielsweise 1,2-Naphthochinon-2-diazid-4-sulfonylchlorid, chromophor substituierte Halogenmethyl-s-triazine sowie Diazoniumsalze, insbesondere Diazonium-tetrafluoroborate und Diazoniumhexafluorophosphate. Geeignete Indikatorfarbstoffe sind beispielsweise kationische Triarylmethan- oder Methin-Farbstoffe.

Soll ein Trägermaterial mit dem strahlungsempfindlichen Gemisch beschichtet werden, wird im allgemeinen eine Lösung des Gemisches aufgetragen. Das Lösemittel ist auf das vorgesehene Beschichtungsverfahren, die Schichtdicke und die Trocknungsbedingungen abzustimmen. Als Lösemittel geeignet sind Ketone, wie Butanon; chlorierte Kohlenwasserstoffe (wie Trichlorethylen und 1,1,1-Trichlorethan), Alkohole (wie n-Propanol), Ether (wie Tetrahydrofuran), Glykolmonoether (wie Ethylenglykol-monoalkylether und Propylenglykol-monoalkylether) und Ester (wie Butylacetat und Propylenglykol-monoalkylether-acetat). Es können auch Gemische verschiedener Lösemittel verwendet werden. In speziellen Fällen kann es vorteilhaft sein, noch weitere Lösemittel, wie Acetonitril, Dioxan, Dimethylacetamid oder Dimethylsulfoxid, mitzuverwenden. Im Prinzip sind alle Lösemittel geeignet, die mit den Bestandteilen des Gemisches nicht irreversibel reagieren. Glykol-monoalkylether, insbesondere Ethylenglykol-monomethylether und Propylenglykol-monomethylether, sind besonders bevorzugt.

Die Trägermaterialien bestehen gewöhnlich aus Metall. Strahlungsempfindliche Aufzeichnungsmaterialien für die Herstellung von Offsetdruckplatten haben als Trägermaterial in der Regel walzblankes, mechanisch und/oder elektrochemisch aufgerauhtes und gegebenenfalls anodisiertes Aluminium. Das Aluminium-Trägermaterial kann auch noch chemisch vorbehandelt sein, beispielsweise mit Polyvinylphosphonsäure, Silikaten, Phosphaten, Hexafluorozirkonaten oder mit hydrolysiertem Tetraethylorthosilikat.

Die Beschichtung selbst erfolgt in an sich bekannter Weise durch Aufschleudern, Aufsprühen, Eintauchen oder durch Auftragen mit Walzen, Breitschlitzdüsen, Rakeln oder Gießern.

Zur Herstellung einer Druckform wird das strahlungsempfindliche Aufzeichnungsmaterial in einem Vakuum-Kontaktkopierrahmen unter einer Filmvorlage bildmäßig bestrahlt und anschließend mit einem wäßrig-alkalischen Entwickler entwickelt. Zur Bestrahlung sind Röhrenlampen, Xenonimpulslampen, mit Metallhalogenid dotierte Quecksilberdampflampen oder Kohlebogenlampen geeignet. Der wäßrig-alkalische Entwickler kann neben Alkalisilikaten noch geringe Mengen an Puffersubstanzen, Lösemitteln, Tensiden, Reduktionsmittel, Entschäumer, Komplexbildner, Korrosionsinhibitoren und/oder Hydrotrope enthalten. Er kann darüber hinaus auch noch Carbon-, Sulfon- und/oder Phosphonsäure enthalten. Die Normalität des Alkalisilikat-Entwicklers beträgt vorzugsweise 0,2 bis 1,0 val/l. Nach dem Entwickeln kann die Druckform noch gummiert werden.

Die Erfindung wird anhand der folgenden Beispiele näher erläutert, ohne sie hierauf zu beschränken. Vergleichsbeispiele sind mit einem * gekennzeichnet. Gt bedeutet "Gewichtsteile". Alle anderen Abkürzungen sind nachstehend aufgeführt.
1. Kenngrößen der Dispersion
   - FK: Festkörpergehalt der Dispersion (in Gew.-%)
   - SG: Säure- und/oder Salzgruppengehalt (mmol/g Harz)
   - TG: Glastemperatur (°C)
2. Kenngrößen der Schichttopographie
   - D: mittlerer Kalottendurchmesser (µm)
   - Dm: maximaler Kalottendurchmesser (µm)
   - H: mittlere Höhe der Kalotten (µm)
   - Hm: maximale Höhe der Kalotten (µm)
   - n: Anzahl der Kalotten pro cm²
3. Prüfkriterien
   - T: Evakuierzeit in Sekunden zur Kontaktierung Filmvorlage/Flachdruckplatte
   - K: Kalotten in Bildstellen nach Entwicklung:
   + = vorhanden
   0 = teilweise vorhanden
   - = abgelöst
   - S: Spots in Nichtbildstellen nach Entwicklung:
   + = keine Spots
   - = Spots vorhanden
   - R: Rasterruhe; die Gleichmäßigkeit der Wiedergabe eines großflächigen 60er Rasters mit 20 % Flächendeckung wird visuell wie folgt bewertet:
   + = keine Ausbrüche,
   0 = vereinzelt Ausbrüche, leichte Rasterunruhe,
   - = viele Ausbrüche, starke Rasterunruhe,
   - C: Corona = Breite der Zone in mm um einen 300 µm dicken Abstandshalter zwischen Druckplatte und 60er-Raster-Film mit 20 % Flächendeckung, in dem die Rasterpunkte nicht wiedergegeben werden. Bei diesem Test wird die Anfälligkeit gegenüber Lufteinschlüssen untersucht,
   - U: Mikrolinienanzeige im UGRA-Offset-Testkeil.

### Beispiel 1

Eine in Salzsäure elektrolytisch aufgerauhte (R_{z}-Wert nach DIN 4768: 5,0 µm), 0,3 mm dicke Aluminiumfolie wurde in Schwefelsäure zwischengebeizt und eloxiert (Oxidgewicht 3,0 g/m²), mit Polyvinylphosphonsäure hydrophiliert und anschließend mit folgender Lösung beschichtet:

| | |
|---|---|
| 5,00 Gt | Kresol-Formaldehyd-Novolakharz mit einer Hydroxylzahl von 420 nach DIN 53 783/53 240 (entsprechend einem Hydroxylgruppengehalt von 7,5 mmol/g und einem mittleren Molekulargewicht M_{w} von 10 000) [bestimmt durch Gelpermeationschromatographie (GPC) mit einem Polystyrol-Standard], |
| 1,20 Gt | eines Veresterungsproduktes aus 3 mol 1,2-Naphthochinon-2-diazid-5-sulfonylchlorid und 1 mol 2,3,4-Trihydroxybenzophenon, |
| 0,15 Gt | 1,2-Naphthochinon-2-diazid-4-sulfonylchlorid, |
| 0,05 Gt | Viktoriareinblau (C.I. 44 045) und |
| 93,60 Gt | eines Gemisches aus Butanon und Propylenglykolmonomethylether (40/60). |

Die Kopierschicht wurde 1 min bei 125 °C getrocknet. Das Schichtgewicht betrug 2,4 g/m².

Anschließend wurde, elektrostatisch unterstützt, mit Hilfe einer Hochrotationsglocke die wäßrige Dispersion eines Methacrylsäure-Methylmethacrylat-Ethylacrylat-Copolymeren aufgesprüht.

### Dispersionskenndaten:

FK = 20, anionischer Stabilisator gemäß allgemeiner Formel, in der R¹ = C₉H₁₉-Phenyl-, R² = H, n = 8 und Y = SO₃⁻ ist. Kation: Na⁺. Der Anteil an Methacrylsäure variierte bei konstantem Anteil an Ethylacrylat wie in Tabelle 1 beschrieben.

**Tabelle 1**

| Beispiel Nr. | SG | in Gew.-% | T_{g} |
|---|---|---|---|
| 1-1 | 0,18 | 1,5 | ≥ 75°C |
| 1-2 | 0,36 | 3,0 | ≥ 75°C |
| 1-3 | 0,53 | 4,6 | ≥ 75°C |
| 1-4 | 0,71 | 6,1 | ≥ 75°C |
| 1-5* | 0,89 | 1,5 | ≥ 75°C |
| 1-6* | 2,32 | 19,9 | ≥ 75°C |

| Sprühbedingungen | |
|---|---|
| Abstand der Sprühglocke zum Substrat: | 15 cm |
| Glockendrehzahl: | 20 000 Upm |
| Glockendurchmesser: | 6 cm |
| Potentialdifferenz: | 40 kV |
| Infrarot-Trockung | |

Aus der Bildanalyse ergeben sich folgende Werte für die Kalottenbelegung: D = 30-35 µm, Dm = 60-70, H = 3-4, Hm = 7-9 und n = 2 000 bis 3 000.

Eine Hälfte der Platte wurde mit einer lichtundurchlässigen Folie abgedeckt, während auf die andere eine Testvorlage gelegt wurde. Anschließend wurde in einem Vakuum-Kontaktkopierrahmen mit einer 5-kW-Metallhalogenid-Quecksilberdampflampe einem Abstand von 110 cm 90 s lang auf Filmkantenfreiheit hin belichtet. Entwickelt wurde in einem Tauchbadentwicklungsgerät mit einer Bürste bei einer Verarbeitungsgeschwindigkeit von 0,8 m/min mit einer Entwicklerlösung der folgenden Zusammensetzung:

| | |
|---|---|
| 0,45 mol/l | Na₂SiO₃ |
| 10 g/l | Benzoesäure und |
| 1 g/l | Nonylphenolethoxylat (HLB-Wert: 13) |

Es wurden die in Tabelle 1a) wiedergegebenen Resultate erhalten.

**Tabelle 1a):**

| Beispiel Nr. | T | K | S | R | C | U |
|---|---|---|---|---|---|---|
| 1-1 - 1-4 | <20 | + | + | + | ≤ 25 | 12 |
| 1-5* | <20 | 0 | + | + | ≤ 25 | 12 |
| 1-6* | <20 | - | + | + | ≤ 25 | 12 |

Daraufhin wurde die Testvorlage auf die unbelichtete Plattenhälfte aufgelegt und nochmals wie oben beschrieben kontaktiert, belichtet und entwickelt. Daraus resultieren die in Tabelle 1b) dargestellten Ergebnisse.

**Tabelle 1b):**

| Beispiel | T | K | S | R | C | U |
|---|---|---|---|---|---|---|
| 1-1 - 1-4 | < 20 | + | + | + | ≤ 25 | 12 |
| 1-5* | 24 | 0 | + | 0 | 29 | 12 |
| 1-6* | 28 | - | + | - | 36 | 12 |
| | | | | | | |

Die Ergebnisse zeigen, daß nur bei den erfindungsgemäßen Materialien ein unkritisches Verhalten bei den Unterstrahlungstests nach einem Entwicklungsschritt vorliegt.

### Beispiel 2

Eine in Salzsäure elektrolytisch aufgerauhte (R_{z}-Wert nach DIN 4768: 3,2 µm), 0,3 mm dicke Aluminiumfolie wurde in Schwefelsäure zwischengebeizt und eloxiert (Oxidgewicht 2,0 g/m²), mit Polyvinylphosphonsäure hydrophiliert und anschließend mit folgender Lösung beschichtet:

| | |
|---|---|
| 4,80 Gt | Kresol-Formaldehyd-Novolakharz mit einer Hydroxylzahl von 420 nach DIN 53 783/53 240 und einem mittleren Molekulargewicht M_{w} von 6 000 (bestimmt durch GPC mit Polystyrol-Standard), |
| 1,05 Gt | eines Veresterungsproduktes aus 3 mol 1,2-Naphthochinon-2-diazid-4-sulfonylchlorid und 1 mol 2,3,4-Trihydroxybenzophenon, |
| 0,30 Gt | Bis-(4-Hydroxy-phenyl)-sulfon, |
| 0,05 Gt | 2-(4-Styryl-phenyl)-4,6-bis-trichlormethyl-s-triazin, |
| 0,10 Gt | Kristallviolett (C.I. 42 555) und |
| 93,7 Gt | eines Gemisches aus Tetrahydrofuran und Propylenglykol-monomethylether (55/45). |

Der Beschichtung wurde 1 min bei 125 °C getrocknet. Das Schichtgewicht betrug 1,8 g/m².

Anschließend wurde, elektrostatisch unterstützt, mit einer Hochrotationsglocke die wäßrige Dispersion eines- Methacrylsäure-Styrol-Ethylacrylat-Copolymers mit einem Methacrylsäuregehalt von 0,46 mmol/g entsprechend 4 Gew.-% Methacrylsäure aufgesprüht.

### Dispersionskenndaten:

T_{g} ca. 70 °C, FK = variierte entsprechend Tabelle 2a), anionischer Stabilisator gemäß allgemeiner Formel, in der R¹ = C₉H₁₉-Phenyl-, R² = H, n = 8 und Y = SO₃⁻ ist. Kation: Na⁺. Schutzkolloid: 15 Gew.-% Polyvinylakohol (^{(R)}Mowiol 3-83 der Hoechst AG) bezogen auf FK.

| Sprühbedingungen | |
|---|---|
| Abstand der Sprühglocke zum Substrat: | 15 cm |
| Glockendrehzahl: | 25 000 Upm |
| Glockendurchmesser: | 6 cm |
| Potentialdifferenz: | 35 kV |
| kombinierte Konvektions-/IR-Trocknung | |

Daraus resultierte die in Tabelle 2a) dargestellte Kalottenbelegung.

**Tabelle 2a):**

| Beispiel | FK | D | Dm | H | Hm | n |
|---|---|---|---|---|---|---|
| 2-1 | 30 | < 40 | < 80 | 6 | < 10 ca. | 2 000 |
| 2-2 | 25 | < 40 | < 80 | 5 | < 10 ca. | 2 000 |
| 2-3 | 20 | < 40 | < 80 | 4 | < 10 ca. | 2 000 |
| 2-4 | 15 | < 40 | < 80 | 3 | < 10 ca. | 2 000 |
| 2-5* | 10 | < 40 | > 80 | 2 | < 10 ca. | 2 000 |
| 2-6* | 5 | < 40 | > 80 | 1 | < 10 ca. | 2 000 |

Eine Testvorlage wurde auf eine Platte gelegt und in einem Vakuum-Kontaktkopierrahmen mit einer 5-kW-Metallhalogenid-Quecksilberdampflampe in einem Abstand von 110 cm 60 s lang belichtet. Danach wurde die Platte in einem Durchlauftemperofen mit integrierter Wasserkühlung mit IR-Strahlung auf 140 °C erhitzt, ohne Vorlage belichtet und anschließend in einem Tauchbadentwicklungsgerät mit Bürste bei einer Verarbeitungsgeschwindigkeit von 0,6 m/min in einer Entwicklerlösung folgender Zusammensetzung entwickelt:

| | |
|---|---|
| 0,35 mol/l | Na₂SiO₃ |
| 10 g/l | Benzoesäure und |
| 1 g/l | Ethylen-/Propylenoxid-Copolymer (HLB-Wert: 16, mittleres Molekulargewicht M_{w}: 8 000) |

Die in Tabelle 2b) wiedergegebenen Resultate zeigen, daß auch nach einer Positiv/Negativ-Umkehr bei den erfindungsgemäßen Aufzeichnungsmaterialien die Kalotten in den Bildstellen erhalten sind und in den Nichtbildstellen keine Schichtreste zurückbleiben.

**Tabelle 2b):**

| Beispiel Nr. | T | K | S |
|---|---|---|---|
| 2-1 - 2-4 | < 20 | + | + |
| 2-5* | < 20 | + | 0 |
| 2-6* | 23 | + | - |

### Beispiel 3

Eine Aluminiumfolie gemäß Beispiel 1 wurde mit folgender Lösung beschichtet:

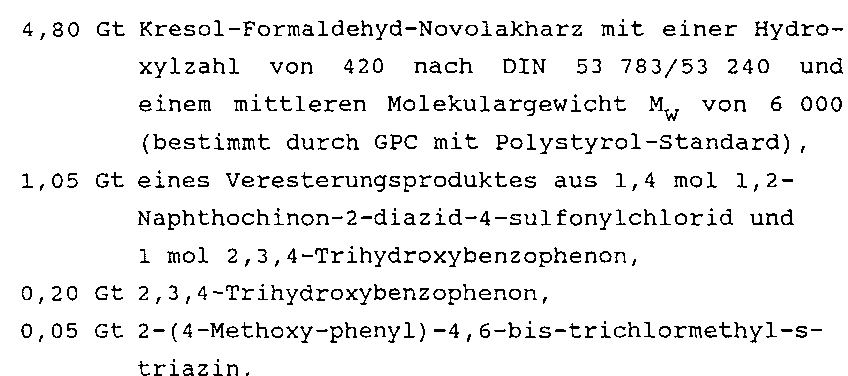

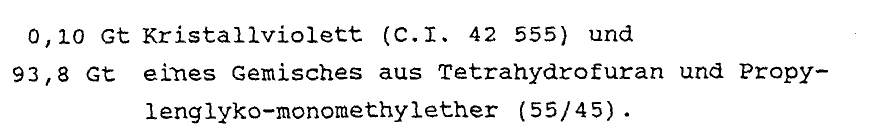

Die Beschichtung wurde 1 min bei 125 °C getrocknet. Das Schichtgewicht betrug 2,0 g/m².

Anschließend wurde mit einer Hochrotationsglocke, elektrostatisch unterstützt, unter den in Beispiel 2 angegebenen Sprühbedingungen eine wäßrige Dispersion eines Zink-Ammoniak-Komplex-Salzes eines Methacrylsäure-Styrol-Ethylacrylat-Copolymeren mit einer Teilchengröße weniger als 100 nm aufgesprüht, wobei durch Variation der Beschichtungsgeschwindigkeit (Tabelle 3a) unterschiedliche Kalottenbelegungen erhalten wurden.

### Dispersionskenndaten:

Tg ca. 75 °C, FK = 20, anionischer Stabilisator gemäß allgemeiner Formel mit R¹ = C₈H₁₇-, R² = H, n = 50 und Y = PO₃²⁻, und nicht-ionischer Stabilisator mit R¹ = C₁₆H₃₃, R² = H, n = 50, Y = H; Anteil an Methacrylat 0,53 mmol/g entsprechend 4,6 Gew.-% Methacrylsäure.

Daraus resultierte die in Tabelle 3 dargestellte Kalottenbelegung.

**Tabelle 3:**

| Beispiel | D | Dm | H | Hm | n |
|---|---|---|---|---|---|
| 3-1* | <20 | <80 | 3 | <10 ca. | 30 |
| 3-2 | <20 | <80 | 3 | <10 ca. | 100 |
| 3-3 | <20 | <80 | 3 | <10 ca. | 500 |
| 3-4 | <20 | <80 | 3 | <10 ca. | 1000 |
| 3-5 | <20 | <80 | 3 | <10 ca. | 9000 |
| 3-6* | <20 | <80 | 3 | <10 ca. | 25000 |

Die Platte wird in einem Vakuum-Kontaktkopierrahmen durch Evakuierung mit einer Negativvorlage kontaktiert und mit einer 5-kW-Metallhalogenid-Quecksilberdampflampe in einem Abstand von 110 cm 60 s lang belichtet. Danach wird sie in einem Durchlauftemperofen mit integrierter Wasserkühlung mit IR-Strahlung auf 140 °C erhitzt, anschließend in einem Vakuum-Kontaktkopierahmen unter einer Positivvorlage mit Testelementen zur Bewertung des Unterstrahlungsverhaltens und der Wiedergabe 90 s belichtet und dann in einem Tauchbadentwicklungsgerät mit Bürste bei einer Verarbeitungsgeschwindigkeit von 0,6 m/min in der Entwicklerlösung mit folgender Zusammensetzung entwickelt:

| | |
|---|---|
| 0,25 mol/l | K₂SiO₃ |
| 10 g/l | Natrium-Cumolsulfonat und |
| 0,5 g/l | Ethylendiamin/Ethylenoxid/Propylenoxid-Copolymer |

Nach einer Evakuierzeit und einer Positivbelichtung von je 20 s wurden für die obigen Beispiele folgende Werte ermittelt: K/S/R = +, C = ≤25, U = 12. Lediglich bei Beispiel 3-1 zeigte sich eine leichte Rasterunruhe. Also auch bei der Composing-Verarbeitung können mit den erfindungsgemäßen Aufzeichnungsmaterialien gute Resultate erzielt werden.

### Beispiel 4

Eine 0,4 mm dicke Aluminiumfolie wird zunächst in einer Bimsmehlsuspension mechanisch und anschließend in Salzsäure elektrolytisch aufgerauht (R_{Z}-Wert nach DIN 4768: 6,0 µm), dann in Schwefelsäure zwischengebeizt und eloxiert (Oxidgewicht 4,0 g/m²), mit Polyvinylphosphonsäure hydrophiliert und mit folgender Lösung beschichtet:

| | |
|---|---|
| 4,50 Gt | eines Copolymerisats von 2-Hydroxyphenyl-methacrylat und Styrol mit einem Hydroxylgruppengehalt von 6,8 mmol/g und einem mittleren Molekulargewicht M_{w} von 15 000 (bestimmt durch GPC mit Polystyrol-Standard), |
| 1,60 Gt | eines Veresterungsprodukts von 1,5 mol 1,2-Naphthochinon-2-diazid-5-sulfonylchlorid und 1 mol 2,3,4-Trihydroxybenzophenon, |
| 0,30 Gt | 1,2-Naphthochinon-2-diazid-4-sulfonylchlorid, |
| 0,05 Gt | Viktoriareinblau (C.I. 44 045) und |
| 93,55 Gt | eines Gemisches aus Methylethylketon und Propylenglykol-monomethylether (40/60). |

Der Beschichtung wird 1 min bei 125 °C getrocknet. Das Schichtgewicht beträgt 2,4 g/m².

Anschließend wird, elektrostatisch unterstützt, mit einer Hochrotationsglocke die wäßrige, anionische Dispersion der folgenden Harze aufgesprüht:
- Beispiel 4-1:: Copolymer aus 88 Gew.-% Vinylidenchlorid, 5 Gew.-% Acrylnitril, 4 Gew.-% Methacrylat und 3 Gew.-% Acrylsäure (entsprechend 0,42 mmol/g),
Stabilisator: Dodecylbenzolsulfonat,
FK = 20.
- Beispiel 4-2:: Copolymer aus 70 Gew.-% Styrol, 24,4 Gew.-% Butylacrylat und 5,6 Gew.-% Natriumethylensulfonat mit einem Sulfonatgehalt von 0,43 mmol/g,
Stabilisator: keiner,
FK = 20.
- Beispiel 4-3:: Copolymer aus 94,4 Gew.-% Vinylacetat und 5,6 Gew.-% Natrium-Ethylensulfonat mit einem Sulfonatgehalt von 0,43 mmol/g,
Stabilisator: keiner,
FK = 18.
- Beispiel 4-4:: Copolymer aus 80 Gew.-% Vinylacetat und 20 Gew.-% Vinylchlorid,
Stabilisator: Dodecylbenzolsulfonat und Polyvinylalkohol (^{(R)}Mowiol 4-88 der Hoechst AG, 10% bezogen auf FK),
FK = 18.

| Sprühbedingungen | |
|---|---|
| Abstand der Sprühglocke zum Substrat: | 15 cm |
| Glockendrehzahl: | 30 000 Upm |
| Glockendurchmesser: | 6 cm |
| Potentialdifferenz: | 35 kV |
| IR-Trocknung | |

Aus der Bildanalyse ergeben sich folgende Werte für die Kalottenbelegung: D = 25-35 µm, Dm = 40-50, H = 3-4, Hm = 8-10 und n = 1 500 bis 2 500.

Eine Hälfte der Platte wird mit einer lichtundurchlässigen Folie abgedeckt, während man auf die andere Hälfte eine Testvorlage legt, sie in einem Vakuum-Kontaktkopierrahmen evakuiert und mit einer mit 5-kW Metallhalogenid dotierten Quecksilberdamplampe in einem Abstand von 110 cm 120 s lang auf Filmkantenfreiheit hin belichtet. Entwickelt wird in einem Tauchbadentwicklungsgerät mit Bürste bei einer Verarbeitungsgeschwindigkeit von 0,8 m/min in einer Entwicklerlösung mit folgender Zusammensetzung:

| | |
|---|---|
| 0,15 mol/l | K₂Si₂O₅ |
| 0,35 mol/l | NaOH |
| 5,00 g/l | Polyglykol-600-dicarbonsäure |
| 10,00 g/l | p-Toluolsulfonsäure |
| 1,00 g/l | Ethylendiamin-tetrakis-methylenphosphonsäure |

Die Ergebnisse sind für alle 4 Copolymeren gleich: T = 20, K/S/R = +, C = ≤25, U = 12.

Daraufhin wird die Testvorlage auf die unbelichtete Plattenhälfte aufgelegt und nochmals wie oben beschrieben kontaktiert, belichtet und entwickelt, ohne daß sich die Resultate ändern. Daraus folgt, daß bei den erfindungsgemäßen Materialien ein unkritisches Verhalten bei den Unterstrahlungstests auch nach einem Entwicklungsschritt vorliegt.

## Patentansprüche

1. Aufzeichnungsmaterial mit einem Träger, einer strahlungsempfindlichen Schicht, die ein 1,2-Naphthochinon-2-diazid und ein in Wasser unlösliches, in wäßrig-alkalischen Lösungen dagegen lösliches, organisches, polymeres Bindemittel enthält, und einer darauf befindlichen Mattierungsschicht aus diskreten Partikeln, dadurch gekennzeichnet, daß die Partikel in einer Menge von 100 bis 10.000 Partikeln/cm² vorliegen und einen mittleren Durchmesser von weniger als 40 µm, einen maximalen Durchmesser von weniger als 80 µm, eine mittlere Höhe von 2 bis 6 µm und eine maximale Höhe von 10 µm aufweisen und ein Harz enthalten, das pro Gramm bis zu 0,80 mmol Säure- und/oder Salzgruppen aufweist, und daß die Mattierungsschicht durch Aufsprühen und Trocknen einer wäßrigen, anionisch oder anionisch/nichtionisch stabilisierten Dispersion des Harzes erhalten wurde.

2. Aufzeichnungsmaterial gemäß Anspruch 1, dadurch gekennzeichnet, daß das Harz eine Gehalt an Säure- und/oder Salzgruppen von 0,01 bis 0,75 mmol/g aufweist.

3. Aufzeichnungsmaterial gemäß Anspruch 1 oder 2, dadurch gekennzeichnet, daß die Säure- oder Salzgruppen Carboxy-, Carboxylat-, Sulfo-, Sulfonat-, Phosphono- oder Phosphonatgruppen sind.

4. Aufzeichnungsmaterial gemäß einem der Ansprüche 1 bis 3, dadurch gekennzeichnet, daß das Harz ein Polyester, Polyamid, Polyurethan oder Polyharnstoff ist, in dem die Säure- und/oder Salzgruppen an die Diol- oder Diamin-Einheiten gebunden sind.

5. Aufzeichnungsmaterial gemäß einem der Ansprüche 1 bis 3, dadurch gekennzeichnet, daß das Harz ein Copolymer mit a) Einheiten aus Acrylsäure, Methacrylsäure, Itaconsäure, Maleinsäure, Vinylsulfonsäure, Styrolsulfonsäure, 2-Acryloylamino-1,1-dimethyl-ethansulfonsäure, Vinylphosphonsäure, und/ oder 2-Acryloylamino-1,1-dimethyl-ethylphosphonsäure (= Acrylamido-isobutylenphosphonsäure) sowie deren Salzen und b) Einheiten aus Acrylsäureestern, Methacrylsäureestern, Acrylamiden, Methacrylamiden, Styrol, Vinylestern und/oder Vinylethern ist.

6. Aufzeichnungsmaterial gemäß einem der Ansprüche 1 bis 5, dadurch gekennzeichnet, daß die strahlungsempfindliche Schicht anionische oberflächenaktive Verbindungen enthält.

7. Aufzeichnungsmaterial gemäß Anspruch 6, dadurch gekennzeichnet, daß die anionischen oberflächenaktiven Verbindungen Anionen der allgemeinen Formel R¹O-(CH₂-CHR²-O)ₙ-Y enthalten, worin
R¹ einen (C₆-C₂₀)Alkylrest oder einen gegebenenfalls (C₁-C₁₈)alkylsubstituierten (C₆-C₁₂)Arylrest,
R² ein Wasserstoffatom oder eine Methylgruppe,
Y eine SO₃⁻-, CH₂-CO₂⁻ oder PO₃²⁻-Gruppe und
n eine ganze Zahl zwischen 0 und 50
darstellt.

8. Aufzeichnungsmaterial gemäß einem der Ansprüche 1 bis 7, dadurch gekennzeichnet, daß die strahlungsempfindliche Schicht nichtionische oberflächenaktive Verbindungen und/oder wasserlösliche Schutzkolloide enthält.

9. Aufzeichnungsmaterial gemäß einem der Ansprüche 1 bis 8, dadurch gekennzeichnet, daß die Anzahl der Partikeln pro Quadratzentimeter 500 bis 5.000 beträgt.

10. Aufzeichnungsmaterial gemäß einem der Ansprüche 1 bis 9, dadurch gekennzeichnet, daß der Anteil an nichtflüchtigen Bestandteilen in der aufgesprühten Dispersion 5 bis 50 Gew.-% beträgt, bezogen auf das Gesamtgewicht der Dispersion.

## Claims

1. A recording material comprising a support, a radiation-sensitive layer containing a 1,2-naphthoquinone-2-diazide and an organic polymeric binder insoluble in water but soluble in aqueous-alkaline solutions, and a matting layer of discrete particles situated thereon, characterised in that the particles are present in a quantity of from 100 to 10,000 particles/cm² and have an average diameter of less than 40 µm, a maximum diameter of less than 80 µm, an average height of from 2 to 6 µm and a maximum height of 10 µm and contain a resin having up to 0.80 mmol of acid groups and/or salt groups per gram, and that the matting layer has been obtained by spraying on and drying an aqueous, anionic or anionic/nonionic stabilised dispersion of the resin.

2. The recording material according to claim 1, characterised in that the resin has a content of acid groups and/or salt groups of from 0.01 to 0.75 mmol/g.

3. The recording material according to claim 1 or 2, characterised in that the acid groups or salt groups are carboxy, carboxylate, sulpho, sulphonate, phosphono or phosphonate groups.

4. The recording material according to one of claims 1 to 3, characterised in that the resin is a polyester, polyamide, polyurethane or polyurea, wherein the acid groups and/or salt groups are bonded to the diol or diamine units.

5. The recording material according to one of claims 1 to 3, characterised in that the resin is a copolymer containing a) units of acrylic acid, methacrylic acid, itaconic acid, maleic acid, vinylsulphonic acid, styrenesulphonic acid, 2-acryloylamino-1,1-dimethylethanesulphonic acid, vinylphosphonic acid and/or 2-acryloylamino-1,1-dimethylethylphosphonic acid (= acrylamidoisobutylenephosphonic acid) and the salts thereof and b) units of acrylic esters, methacrylic esters, acrylamides, methacrylamides, styrene, vinyl esters and/or vinyl ethers.

6. The recording material according to one of claims 1 to 5, characterised in that the radiation-sensitive layer contains anionic surface-active compounds.

7. The recording material according to claim 6, characterised in that the anionic surface-active compounds contain anions corresponding to the general formula R¹O-(CH₂-CHR²-O)ₙ-Y, wherein
R¹ is a (C₆-C₂₀) alkyl group or an optionally (C₁-C₁₈) alkyl-substituted (C₆-C₁₂) aryl group,
R² is a hydrogen atom or a methyl group,
Y is an SO₃⁻, CH₂-CO₂⁻ or PO₃²⁻ group and
n is an integer between 0 and 50.

8. The recording material according to one of claims 1 to 7, characterised in that the radiation-sensitive layer contains nonionic surface-active compounds and/or water-soluble protective colloids.

9. The recording material according to one of claims 1 to 8, characterised in that the number of particles per square centimetre is from 500 to 5,000.

10. The recording material according to one of claims 1 to 9, characterised in that the proportion of nonvolatile components in the sprayed-on dispersion is from 5 to 50 wt.%, referred to the total weight of the dispersion.

## Revendications

1. Matériau d'enregistrement avec un support, une couche sensible au rayonnement, qui contient un 1,2-naphtoquinone-2-diazide, et un liant polymère organique insoluble dans l'eau, mais soluble dans les solutions aqueuses alcalines, et une couche de matage qui se trouve au-dessus, constituée de particules discrètes, caractérisé en ce que les particules sont en une quantité de 100 à 10 000 particules par cm², et ont un diamètre moyen inférieur à 40 µm, un diamètre maximum inférieur à 80 µm, une hauteur moyenne de 2 à 6 µm et une hauteur maximale de 10 µm, et contiennent une résine, qui présente par gramme jusqu'à 0,80 mmol de groupes acide et/ou sel, et que la couche de matage a été obtenue par pulvérisation et séchage d'une dispersion aqueuse stabilisée anioniquement et/ou anioniquement / non ioniquement de la résine.

2. Matériau d'enregistrement selon la revendication 1, caractérisé en ce que la résine présente une teneur en groupes acide et/ou sel de 0,01 à 0,75 mmol par gramme.

3. Matériau d'enregistrement selon la revendication 1 ou 2, caractérisé en ce que les groupes acide et/ou sel sont des groupes carboxy, carboxylate, sulfo, sulfonate, phosphono ou phosphonate.

4. Matériau d'enregistrement selon l'une des revendications 1 à 3, caractérisé en ce que la résine est une résine polyester, polyamide, polyuréthane ou polyurée, où les groupes acide et/ou sel sont fixés sur les unités diol ou diamine.

5. Matériau d'enregistrement selon l'une des revendications 1 à 3, caractérisé en ce que la résine est un copolymère de a) des unités d'acide acrylique, acide méthacrylique, acide itaconique, acide maléique, acide vinylsulfonique, acide styrènesulfonique, acide 2-acryloylamino-1,1-diméthyl-éthanesulfonique, acide vinylphosphonique, et/ou acide 2-acryloylamino-1,1-diméthyléthylphosphonique (= acide acrylamido-isobutylènephosphonique), ainsi que leurs sels, et b) des unités d'esters acide acrylique, esters d'acide méthacrylique, acrylamides, méthacrylamides, styrène, esters vinyliques et/ou éthers vinyliques.

6. Matériau d'enregistrement selon l'une des revendications 1 à 5, caractérisé en ce que la couche sensible au rayonnement contient des composés tensio-actifs anioniques.

7. Matériau d'enregistrement selon la revendication 6, caractérisé en ce que les composés tensio-actifs anioniques contiennent des anions de formule
R¹O-(CH₂-CHR²-O)ₙ-Y
où
R¹ est un reste alkyle C₆₋₂₀ ou le cas échéant un reste alkyle C₆₋₁₂ substitué par un alkyle C₁₋₁₈,
R² est un atome d'hydrogène ou un groupe méthyle,
Y est un groupe SO₃⁻, CH₂CO₂⁻ ou PO₃²⁻ et
n est un nombre entier de 0 à 50.

8. Matériau d'enregistrement selon l'une des revendications 1 à 7, caractérisé en ce que la couche sensible au rayonnement contient des composés tensio-actifs non ioniques et/ou des colloïdes protecteurs hydrosolubles.

9. Matériau d'enregistrement selon l'une des revendications 1 à 8, caractérisé en ce que le nombre des particules par centimètre carré est 500 à 5 000.

10. Matériau d'enregistrement selon l'une des revendications 1 à 9, caractérisé en ce que la teneur en composants non volatils dans la dispersion pulvérisée représente 5 à 50% en poids, par rapport au poids total de la dispersion.
